(19)

Europäisches
Patentamt
European
Patent Office
Office européen
des brevets

(11) **EP 3 519 837 B1**

(12) **EUROPEAN PATENT SPECIFICATION**

(45) Date of publication and mention
of the grant of the patent:
**04.11.2020 Bulletin 2020/45**

(51) Int Cl.:
***G01R 27/16*** *(2006.01)*   ***G01R 19/25*** *(2006.01)*

(21) Application number: **17776996.5**

(86) International application number:
**PCT/EP2017/074206**

(22) Date of filing: **25.09.2017**

(87) International publication number:
**WO 2018/060130 (05.04.2018 Gazette 2018/14)**

(54) **METHOD TO ESTIMATE AN EQUIVALENT GRID IMPEDANCE FOR POWER GENERATORS**

VERFAHREN ZUR SCHÄTZUNG EINER ÄQUIVALENTEN NETZIMPEDANZ FÜR
STROMGENERATOREN

PROCEDE DESTINE A ESTIMER UNE IMPEDANCE EQUIVALENTE DE RESEAU POUR
GENERATEURS DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.09.2016 EP 16190791**

(43) Date of publication of application:
**07.08.2019 Bulletin 2019/32**

(73) Proprietor: **ABB Schweiz AG
5400 Baden (CH)**

(72) Inventors:
• **ROHR, Eduardo
5400 Baden (CH)**
• **AL-HOKAYEM, Peter
5415 Nussbaumen (CH)**
• **BAECHLE, Mathias
79805 Eggingen (DE)**

(74) Representative: **Qip Patentanwälte
Dr. Kuehn & Partner mbB
Goethestraße 8
80336 München (DE)**

(56) References cited:
**US-A1- 2015 025 860**

• **COBRECES S ET AL: "Grid Impedance
Monitoring System for Distributed Power
Generation Electronic Interfaces", IEEE
TRANSACTIONS ON INSTRUMENTATION AND
MEASUREMENT, IEEE SERVICE CENTER,
PISCATAWAY, NJ, US, vol. 58, no. 9, 2 September
2009 (2009-09-02), pages 3112-3121,
XP011269404, ISSN: 0018-9456, DOI:
10.1109/TIM.2009.2016883**
• **Md. Umar Hashmi ET AL: "Online Thevenin
Equivalent Parameter Estimation using
Nonlinear and Linear Recursive Least Square
Algorithm", , 20 July 2016 (2016-07-20),
XP055330158, Retrieved from the Internet:
URL:https://arxiv.org/ftp/arxiv/papers/161
0/1610.05142.pdf [retrieved on 2016-12-14]**

EP 3 519 837 B1

**Description**

FIELD OF THE INVENTION

The invention relates to the field of control of power plants. In particular, the invention relates to a method for estimating an equivalent impedance of a power grid, a controller, a control system and a power plant.

BACKGROUND OF THE INVENTION

An electric power plant may comprise one or more generators that are interconnected with an electrical power grid, which usually is a large scale grid for distributing the generated electrical energy along a long distance. In order to optimize the performance of the plant and react to grid events, such as faults, sags, etc., it usually is of importance to know the equivalent grid impedance, which may be used for controlling the power plant. For example, in the case of a fault, the power grid may be restructured, which usually changes its impedance seen by the power plant.

In US 2015 0025860 A1, a method for estimating grid properties of a power grid is described, in which a grid impedance is calculated based on a measured voltage, current and phase angle at the point of common coupling of a single generator.

The article "Grid Impedance Monitoring System for Distributed Power Generation Electronics Interfaces", IEEE Transactions on instrumentation and measurement, IEEE service center, Piscataway, NJ, US, vol. 58, no. 9, 1 September 2009, pages 3112-3121 by Cobreces et al. describes a method, how an islanding condition of a renewable energy source may be detected. It is proposed to monitor the grid and to estimate the grid impedance based on a grid model. The impedance estimation is based on minimizing a cost function.

DESCRIPTION OF THE INVENTION

It is an objective of the invention to estimate a grid impedance of a power grid supplied by an electrical generator in a simple and effective way.

This objective is achieved by the subject-matter of the independent claims. Further exemplary embodiments are evident from the dependent claims and the following description.

An aspect of the invention relates to a method for estimating a grid impedance of a power grid. For example, the method may be performed by a controller of the power plant or a generator of the power plant. It has to be noted that the generator may be a rotating electrical machine but also may be another device adapted for generating an AC voltage, such as a combination of a PV panel and an inverter.

According to an embodiment of the invention, the method comprises: measuring a plurality of measurement values of a generator voltage and a generator current of at least one generator connected to the power grid; generating a performance index from the plurality of measurement values, the performance index being a function of the measurement values and the grid impedance; and determining an equivalent impedance as the grid impedance, which minimizes the performance index.

The performance index is additionally a function of an angular error, which accounts for a deviation of a grid frequency at a measurement of a measurement value from a nominal grid frequency, and the performance index is additionally minimized with respect to the angular error.

The measurement values may comprise voltage values and current values that may have been measured at different time points during a specific time interval. For getting a good estimate, voltage values and current values at more than one time point may be measured. It may be that the measurement values are measured in one or more phases of the generator and/or the power grid.

The angular error at a time point may be defined by a difference of the nominal angle of the grid voltage at this time point and the angle of the measured grid voltage. The nominal angle may be determined from a nominal grid frequency, for example by fitting the measured grid voltage values to a sinusoidal voltage. The grid voltage may be modelled as a sinusoidal voltage and the angular error may account for deviations from this sinusoidal voltage. The angular error may comprise a value for every measurement and/or for every measurement time.

The acquired measurement values are used for generating a function, called performance index, which is a function of the grid impedance, the angular arror and the measurement values, and that is constructed such that it is minimal, when the grid impedance and the angular error best fits the measurement values. The performance index may be based on a set of functions, wherein each function is generated from the measurement values at one time point. The performance index may be a nonlinear function to have a minimum. The optimal impedance value which best fits with the measurement values to minimize the performance index is chosen as the equivalent impedance. The equivalent impedance may be determined by solving the optimization problem of finding the grid impedance value with the lowest performance index online.

A grid impedance as well as the equivalent impedance may comprise a grid resistance and a grid inductance.

Moreover, it may be possible that specific acceptance criteria may be used in order to assess if the equivalent impedance is valid. For example, only grid impedances within a predefined interval may be accepted. It also may be possible that only an equivalent impedance is accepted that differs from a previous estimated not more than a predefined value. In the case, the equivalent impedance is rejected, i.e. not accepted, the method may be repeated until an acceptable equivalent impedance is determined.

The method may be triggered whenever the operating conditions of the generating unit are changing. In particular, the estimation is getting better, when the measurement values are measured at a plurality of different operation points of the generator.

According to an embodiment of the invention, the performance index is minimized in a first step with the angular error set to zero for determining an intermediate equivalent impedance. In the first step, the equivalent impedance may be determined under the assumption that there is no angular error, for example no deviation from a sinusoidal grid voltage. In other word, in a set of equations defining the performance index, the angular error is set to zero and this performance index is minimized for determining the intermediate equivalent impedance.

In a second step, the performance index may be minimized with the equivalent impedance set to the intermediate equivalent impedance, which has been determined in the first step, for determining the angular error. In the set of equations defining the performance index, the equivalent impedance is set to the value(s) determined in the previous step and the performance index may be minimized to determine the angular error.

In a third step, the performance index may be minimized with the angular error determined in the second step kept fixed for determining the final equivalent impedance. In the set of equations defining the performance index, the values for the angular error are set to the values determined in the previous step and the performance index may be minimized to determine the final equivalent impedance.

According to an embodiment of the invention, the measurement values are measured at a plurality of different operation points of the at least one generator. Different operation points may differ in a phase angle between the generator voltage and the generator current. Furthermore different operation points may differ in a magnitude of the generator voltage and/or in a magnitude of the generator current. For example, the measurement values may be taken at more than one different operation points.

According to an embodiment of the invention, the method further comprises: actively varying an operation point of the generator; and measuring the plurality of measurement values during the variation of the operation point.

An operation point may be based and/or may be defined on a phase angle between the generator voltage and the generator current, on a magnitude of the generator voltage and/or on a magnitude of the generator current.

One possibility to change the operation conditions is to control the generator in such a way that its operation point is changing. In such a way, measurement values at different operation points may be taken. For example, the equivalent impedance may be determined during commissioning of the generator and/or the power plant by variation of the operating point. In such a way, a first equivalent impedance may be determined.

It is however also possible that the control of the generator is not changed for performing the method. The method simply may be performed, when a change in operation conditions has been detected, such as a fault in the power grid. Usually, after a fault, the grid impedance changes due to a reconfiguration of the grid (other lines may be used, lines may be disconnected, etc.)

According to an embodiment of the invention, the method further comprises: detecting a fault in the power grid; after clearance of the fault, measuring the plurality of measurement values and determining the equivalent impedance as changed grid impedance. Usually, after a fault, the grid is reconfigured, which usually results in a new grid impedance. Furthermore, after the fault, the equivalent impedance may be determined without any active variation of the operating point, since due to the fault, the operation point usually changes due to the dynamical situation generated by the fault.

According to an embodiment of the invention, the method further comprises: measuring branch currents of a plurality of generators connected to the power grid; and determining the generator current as a sum of the branch currents. For example, the generator current may be the sum of branch currents provided by a plurality of generators connected in parallel to the power grid. When more than one generator is present in a power plant, the grid impedance estimation may be performed based on the total plant current. A plant-wide estimation method may be performed by aggregating all the current measurements that are taken by the various generators in the same power plant. It is not necessary to perform the method for each generator individually.

According to an embodiment of the invention, the performance index is based on a grid model, which comprises solely the grid impedance connected in series with an ideal voltage source providing a grid voltage. It may be assumed that the grid may be represented by an ideal voltage source that is connected in series with a single impedance, which may comprise a resistance and an inductance. From this model, differential equations for the grid voltage in dependence of the grid impedance, the generator current and the generator voltage may be derived.

According to an embodiment of the invention, the performance index is the norm of a vector, the entries of the vector being based on a set of equations, such that by minimizing the performance index, the set of equations is solved.

For example, every equation may be generated from the measurement values at one time point and/or one operation point. These equations may be put into a form that a mathematical formula of the measurement values and the parameters of the grid impedance is zero. These formulas are the entries of the vector. When the length of the vector is minimized, i.e. every entry is moved as close to zero as possible, also all the formulas are substantially zero and therefore the equations are at least approximately solved.

Each equation of the set of equations is an equation of the grid impedance, of the angular error, and of measurement values at one measurement time and/or operation point, which models the power grid. The equations may be based on the above-mentioned model of the grid.

According to an embodiment of the invention, the performance index is minimized by an iterative method. There are several possibilities, how the performance index may be minimized numerically, for example with an iterative gradient descent method.

According to an embodiment of the invention, the method further comprises: controlling the at least one generator based on the equivalent impedance. The equivalent impedance may be used for adjusting one or more further controllers of the at least one generator and/or the power plant. For example, the equivalent impedance may be used for online re-adjusting one or more controllers during operation and/or after grid faults and other grid events (such as, for example, tap changes on a transformer, re-closures, etc.). The equivalent impedance also may be used for monitoring the grid.

According to an embodiment of the invention, a transformer and/or a circuit breaker is connected between the power grid and a measurement point at which the generator voltage and the grid current are measured, wherein the equivalent impedance includes a transformer impedance of the transformer and/or a circuit breaker impedance of the circuit breaker. It may be that not only the impedance of the grid but of further equipment connected between the generator and the grid is estimated. In this case, the generator voltage and the generator current may be measured at a point between this equipment (such as the transformer and/or the circuit breaker) and the generator.

A further aspect of the invention relates to an estimator of a power plant, which estimator may be a controller and/or which is adapted for performing the method as described in the above and in the following. The method may be implemented in the estimator in any possible way, in software, in hardware or a mixture thereof. For example, the method may be implemented as software modules that are executed in the estimator by a single or multicore processor.

The estimator may comprise a central computing unit for online minimizing the performance index or the estimator may comprise distributed computing units for online minimizing the performance index. The computation may be carried out in a centralized controller (in a single, central computational unit) or decentralized/distributed controller (in multiple, distributed computational units). However, it also may be possible that the method is at least partially implemented in hardware, in remote devices and/or may comprise a DSP or FPGA.

A further aspect of the invention relates to a control system for an electrical generator. The control system may comprise one or more controllers, and in particular the grid impedance estimator.

According to an embodiment of the invention, the control system comprises a grid impedance estimator adapted for performing the method as described in the above and in the following and at least one further controller for controlling the at least one generator, wherein the at least one further controller is adapted for controlling the generator based on the equivalent impedance.

The equivalent impedance may be used for increasing the overall performance of the generator. In general, a changed grid impedance may have impact on the operation of the generator. These changes may be accounted for in a further controller of the generator, which receive the equivalent impedance and/or control parameters determined from the equivalent impedance.

A further aspect of the invention relates to a power plant with at least one generator interconnected to a power grid and a control system as described in the above and in the following for controlling the at least one generator.

It has to be understood that features of power plant as well as of the controller as described in the above and in the following may be features of the method as described in the above and in the following, and vice versa.

These and other aspects of the invention will be apparent from and elucidated with reference to the embodiments described hereinafter.

BRIEF DESCRIPTION OF THE DRAWINGS

The subject matter of the invention will be explained in more detail in the following text with reference to exemplary embodiments which are illustrated in the attached drawings.

Fig. 1 schematically shows a power plant according to an embodiment of the invention.
Fig. 2 shows a model for a power grid used in a method for estimating a grid impedance according to an embodiment of the invention.
Fig. 3 shows a method for estimating a grid impedance according to an embodiment of the invention.
Fig. 4 shows a diagram with a generator voltage during a grid fault.

Fig. 5 shows a diagram with a generator current during a grid fault.
Fig. 6 shows a diagram with an equivalent impedance determined with a method according to an embodiment of the invention.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

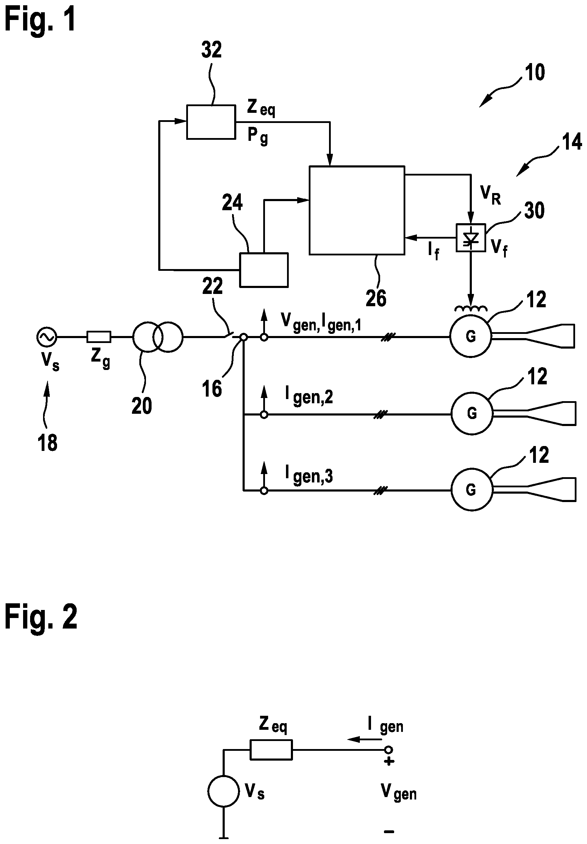

Fig. 1 shows a power plant 10 comprising a plurality of generators 12 and a control system 14 for the generators 12. The generators are connected at a point 16 in parallel to a power grid 18. Between the grid 18 and the point 16, also a transformer 20 and a main circuit breaker 22 may be connected in series. It has to be understood that the generators 12 and the grid 18 may be multi-phase systems (usually with three phases).

In particular, the grid voltage $V_s$ as well as the generator voltage $V_{gen}$ and the generator current $I_{gen,i}$ of a generator 12 may be multi-phase or three-phase quantities.

The control system 14 comprises a measurement and synchronisation unit 24, which receives measurement signals for the generator voltages $V_{gen}$ and the generator current $I_{gen,i}$, which may be measured between the point 16 and the respective generator 12.

The unit 24 may estimate specific quantities of the power plant 10 and/or the respective generator 12, such as an actual frequency $w$, an active power $P$, a reactive power $Q$ and a grid voltage $V_g$, which may be supplied to a further controller 26 adapted for controlling one or all of the generators 12. For example, the controller 26 may provide a control voltage $V_R$ to an excitation system 30 of the respective generator 12.

Furthermore, the control system 14 comprises a grid impedance estimator 32, which also receives measurement values of the generator voltage $V_{gen}$ and the generator current $I_{gen,i}$ from the unit 24. As explained below in detail, the grid impedance estimator 32 estimates an equivalent impedance $Z_{eq}$ of the grid 18. The equivalent impedance $Z_{eq}$ may be composed of a real part related to the ohmic resistance component of the grid impedance and an imaginary part related to the reactive component of the grid impedance. The equivalent impedance $Z_{eq}$ and/or further control parameter $p_g$ may be supplied to the further controller 26 of the control system 14 to enhance its control properties.

As shown in Fig. 2, the power grid 18 may be modelled as a Thevenin equivalent circuit with a series connection of an equivalent voltage source Vs and equivalent impedance $Z_{eq}$, which is assumed to be the equivalent impedance seen by the generators 12.

Due to the measurement behind the connection point 16, the equivalent impedance $Z_{eq}$ includes the (pure) impedance $Z_g$ of the grid 18 as well as the impedance $Z_{CB}$ of the main circuit breaker 22 and the impedance $Z_T$ of the step-up transformer 20, i.e.,

$$Z_{eq} = Z_T + Z_{CB} + Z_g \qquad\qquad (1)$$

Furthermore, the overall generator current or plant current $I_{gen}$ is the sum of the generator currents $I_{gen,i}$ of the generators 12.

$$I_{gen} = I_{gen,1} + \cdots + I_{gen,N} \qquad\qquad (2)$$

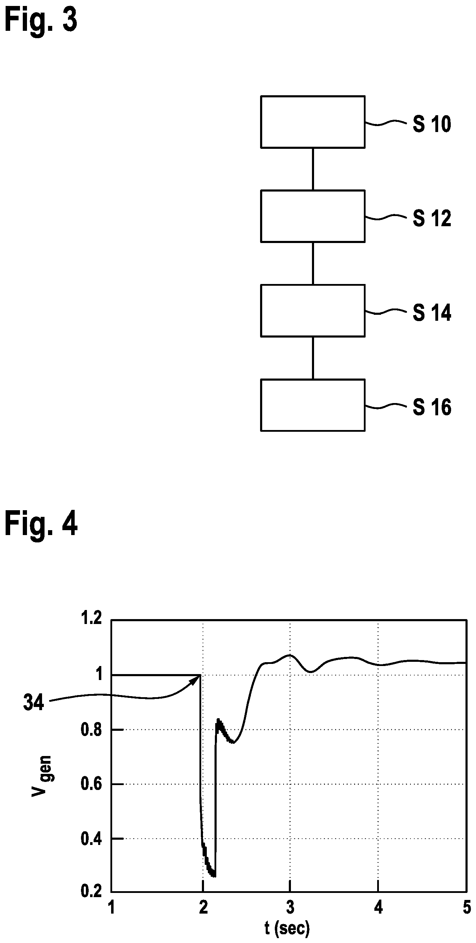

Fig. 3 shows a diagram illustrating a method for estimating the grid impedance $Z_{eq}$, which may be performed by the estimator 32 optionally together with other components of the control system 14.

In step S10, a plurality of measurement values of the generator voltage $V_{gen}$ and the generator current $I_{gen}$ are measured. For example, the unit 24 of each generator 12 may measure the generator voltage $V_{gen}$ and the generator current $I_{gen,i}$ at the armature terminals of at least one phase. The individual generator current $I_{gen,i}$ may then be summed up.

The measurement values may comprise pairs of voltage values and current values for each phase at a specific measurement time point. Furthermore, a sequence of such measurement values and/or pairs over consecutive time points during a measurement interval may be measured. It has to be noted that from such a sequence, also a derivative of the generator voltage $V_{gen}$ and/or the generator current $I_{gen}$ at the time points may be determined.

For increasing the accuracy of the method, the measurement values may be measured at a plurality of different operation points of the generator 12. For example, such different operation points may be generated actively by controlling the generators actively or the method may wait for a dynamical situation of the power plant 10, such as a grid fault and may then begin to perform the method.

In step S12, the estimator 32 generates a performance index $J$ from the plurality of measurement values. In general, the performance index is a function of the generator voltage $V_{gen}$, the generator current $I_{gen}$ at different time points and the grid impedance $Z_{eq}$. Thus, by inputting the measurement values and/or quantities derived therefrom into the performance index, a non-linear function of the grid impedance $Z_{eq}$ may be generated. The performance index $J$ may depend on further unknown quantities besides the grid impedance $Z_{eq}$.

The performance index $J$ may be based on the grid model shown in Fig. 2, which comprises solely the grid impedance $Z_{eq}$ connected in series with an ideal voltage source $V_s$ providing the grid voltage, i.e., the method is applicable to any topology of the grid 18 and/or the power plant 10. As shown below, dynamical equations modelling the grid model and/or considerations on active and reactive power with respect to the grid model may result in a mathematical equation from which the performance index $J$ may be generated by inputting the measurement values.

In step S14, the estimator 32 determines the equivalent impedance $Z_{eq}$ as the grid impedance, which minimizes the performance index $J$. For determining the equivalent impedance $Z_{eq}$, the performance index $J$ may be generated and minimized online.

In particular, the equivalent impedance $Z_{eq}$ may be obtained as the minimizing argument of the nonlinear performance index $J$ of the possibly sampled generator voltage values and generator current values over a specific time interval (i.e. a time horizon) as follows:

$$Z_{eq} = \mathrm{argmin}\left(J\left(Z_{eq}\right) = \sum_{i=1}^{N} L\left(V_{gen,i}, I_{gen,i}, Z_{eq}\right)\right) \qquad (4)$$

In this formula, for each generator index $i$, the quantities $V_{gen,i}$, $I_{gen,i}$ may be seen as vectors of current values and voltage values obtained at different time instants $t_i$, $i=1,...,N$.

One advantage of the method may be that the knowledge of the actual frequency of the grid voltage is not necessary for generating and evaluating above formula. This may be an issue since frequency changes over short time intervals and may be affected by local mechanical oscillations. Furthermore, it is not necessary to directly estimate the value of the source voltage $V_s$ as it is done by methods that rely on harmonic data profiles.

In step S16, optionally specific acceptance criteria may be used in order to assess if the equivalent impedance $Z_{eq}$ is valid. For example, the actually determined equivalent impedance $Z_{eq}$ may be compared with previous values and/or with predefined bounds for checking, whether it comprises valid value or not.

Furthermore, further control parameters may be determined based on the equivalent impedance $Z_{eq}$.

In the end, the equivalent impedance $Z_{eq}$ and the optional further control parameters may be input to the further controller 26, which then use these parameters for controlling one or more of the generators 12 based on the equivalent impedance $Z_{eq}$.

As mentioned above, it may be possible to actively vary an operation point of the one or more generators during measuring the plurality of measurement values in order to increase the accuracy of the method. For example, for determining the grid impedance $Z_{eq}$ after start-up of the plant 10 or after commissioning, the control system 14 may control the one or more generators 12 such that different operation points are reached.

Another possibility is that the estimator 32 waits for a dynamical situation, during which the method is then performed.

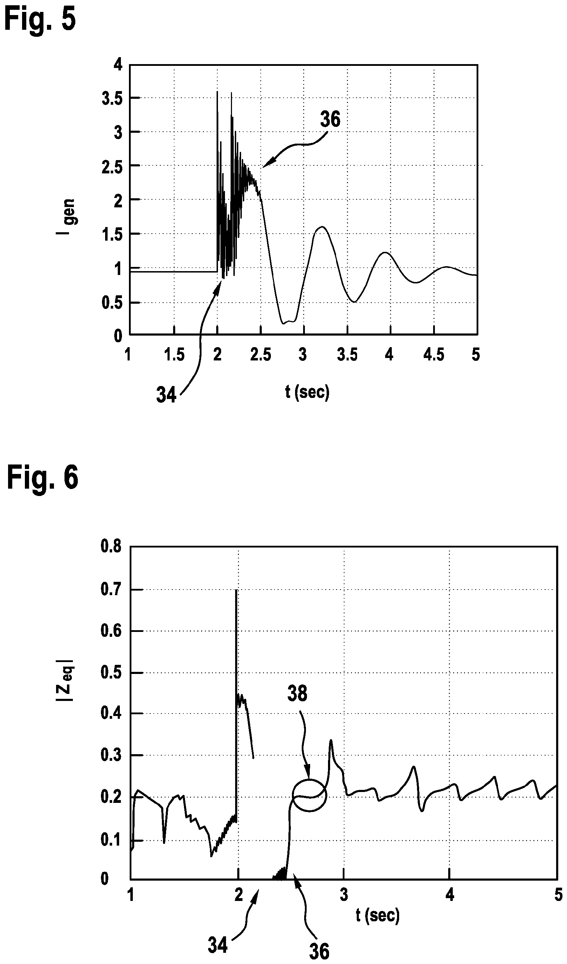

Fig. 4 to 6 relate to such a situation in the form of a grid fault 34. As shown in Fig. 4, the generator voltage $V_{gen}$ at the point 16, for example at the terminals of the generator 12, collapses at t = 2 sec and then slowly recovers towards the nominal value after the fault is cleared at t = 2.15 sec. At the fault clearance 36, the impedance estimation method may be started and produces the correct value 38 of the grid impedance $Z_{eq}$ after the fault occurs and the initial transients in the measurement values have subsided.

The estimator 32 may detect the fault 34, may wait for its clearance, and, after clearance of the fault 34, may estimate the grid impedance $Z_{eq}$.

In the following, one example is given, how the performance index $J$ may be generated and minimized.

One way of solving the estimation problem is to use an extension of a least-squares impedance estimation technique. Since the frequency in the measurements is not constant, we allow an extra degree of freedom to the optimization problem which can help in identifying the correct impedance.

The dynamical equations of the generator 12 and the equivalent voltage source $V_s$ and impedance $Z_{eq}$ are given by

$$L_{eq}\dot{I}_{gen}^{xy} + R_{eq}I_{gen}^{xy} = V_{gen}^{xy} - V_s^{xy} \qquad (4)$$

where $Z_{eq} = R_{eq} + iw_N L_{eq}$ with $w_N$ the known nominal frequency of the grid 18.

Recall the transformation of a variable $Y^{xy}$ into the rotating synchronous $dq$ frame:

$$Y^{xy} = \begin{bmatrix} \cos(\theta) & -\sin(\theta) \\ \sin(\theta) & \cos(\theta) \end{bmatrix} Y^{dq} \tag{5}$$

$$\dot{Y}^{xy} = \begin{bmatrix} \cos(\theta) & -\sin(\theta) \\ \sin(\theta) & \cos(\theta) \end{bmatrix} \dot{Y}^{dq} + \dot{\theta} \begin{bmatrix} -\sin(\theta) & -\cos(\theta) \\ \cos(\theta) & -\sin(\theta) \end{bmatrix} Y^{dq}. \tag{6}$$

The angle $\theta$ is given by

$$\theta = w_N t \tag{7}$$

where $w_N$ is the known nominal frequency of the grid.

Replacing (5) and (6) into (4) and multiplying both sides by the matrix

$$\begin{bmatrix} \cos(\theta) & \sin(\theta) \\ -\sin(\theta) & \cos(\theta) \end{bmatrix} \tag{8}$$

from the left, we obtain

$$L_{eq} \left( \dot{I}_{gen}^{dq} + \dot{\theta} \begin{bmatrix} 0 & -1 \\ 1 & 0 \end{bmatrix} I_{gen}^{dq} \right) + R_{eq} I_{gen}^{dq} = V_{gen}^{dq} - V_s^{dq} \tag{9}$$

Using $X_{eq} = w_N L_{eq}$ and $R_{eq} = \rho X_{eq}$ in (9) and using $\dot{\theta} = w_N$, we obtain

$$X_{eq} \left( \frac{\dot{I}_{gen}^{dq}}{w_N} + \begin{bmatrix} 0 & -1 \\ 1 & 0 \end{bmatrix} I_{gen}^{dq} + \rho I_{gen}^{dq} \right) + V_s^{dq} = V_{gen}^{dq}. \tag{10}$$

Finally, the grid voltage can be modelled as

$$V_s^{xy} = |V_s| \begin{bmatrix} \cos(\theta + \delta(t)) \\ \sin(\theta + \delta(t)) \end{bmatrix}, \tag{11}$$

where the angular error $\delta(t)$ accounts for any deviation at the grid frequency. As shown in (11), the grid voltage may be modelled as a sinusoidal voltage, i.e. as moving on a circle in the complex plane. The angular error $\delta(t)$ may be defined as a difference to the real, measured grid voltage. Applying the *dq* transformation and basic trigonometric identities, we have

$$V_s^{dq} = |V_s| \begin{bmatrix} \cos(\delta(t)) \\ \sin(\delta(t)) \end{bmatrix}. \tag{12}$$

Replacing (12) into (10), we obtain

$$X_{eq}\left(\frac{\dot{I}^{dq}_{gen}}{w_N} + \begin{bmatrix} 0 & -1 \\ 1 & 0 \end{bmatrix} I^{dq}_{gen} + \rho I^{dq}_{gen}\right) + |V_s|\begin{bmatrix} \cos(\delta(t)) \\ \sin(\delta(t)) \end{bmatrix} = V^{dq}_{gen}, \qquad (13)$$

which can be written as two scalar equations:

$$\left(\frac{\dot{I}^{d}_{gen}}{w_N} - I^{q}_{gen} + \rho I^{d}_{gen}\right)X_{eq} + \cos(\delta(t))|V_s| = V^{d}_{gen} \qquad (14)$$

$$\left(\frac{\dot{I}^{q}_{gen}}{w_N} + I^{d}_{gen} + \rho I^{q}_{gen}\right)X_{eq} + \sin(\delta(t))|V_s| = V^{q}_{gen}. \qquad (15)$$

Note that the equations (14), (15) depend on the grid impedance $Z_{eq}$ and of the generator voltage and generator current at one measurement time point and/or one operation point.

Stacking up the equations (14), (15) under different operating points (i.e. different measurement values of generator voltage and current with different angles $\delta_i$) and replacing the sub-index "gen" by the index of the operating point, we obtain

$$A(\delta) = \begin{bmatrix} \dfrac{\dot{I}^{d}_{1}}{w_N} - I^{q}_{1} + \rho I^{d}_{1} & \cos(\delta_1) \\[2mm] \dfrac{\dot{I}^{q}_{1}}{w_N} + I^{d}_{1} + \rho I^{q}_{1} & \sin(\delta_1) \\[2mm] \dfrac{\dot{I}^{d}_{2}}{w_N} - I^{q}_{2} + \rho I^{d}_{2} & \cos(\delta_2) \\[2mm] \dfrac{\dot{I}^{q}_{2}}{w_N} + I^{d}_{2} + \rho I^{q}_{2} & \sin(\delta_2) \\[2mm] \vdots & \vdots \\[2mm] \dfrac{\dot{I}^{d}_{n}}{w_N} - I^{q}_{n} + \rho I^{d}_{n} & \cos(\delta_n) \\[2mm] \dfrac{\dot{I}^{q}_{n}}{w_N} + I^{d}_{n} + \rho I^{q}_{n} & \sin(\delta_n) \end{bmatrix}, \quad b = \begin{bmatrix} V^{d}_{1} \\ V^{q}_{1} \\ V^{d}_{2} \\ V^{q}_{2} \\ \vdots \\ V^{d}_{n} \\ V^{q}_{n} \end{bmatrix}$$

$$(16)$$

which we can use to define the following optimization problem

$$\min_{(\delta,\lambda)} J(\delta,\lambda) = \left\| A(\delta)\lambda - b \right\|^2_2, \quad \lambda = \begin{bmatrix} X_{eq} \\ V_s \end{bmatrix} \qquad (17)$$

In the present example, the performa index $J$ is the norm of a vector, the entries of the vector being based on the set of equations (14), (15), i.e. $A(\delta)\lambda - b = 0$, such that by minimizing the performance index $J$ the set of equations is solved.

The optimization problem (17) is a non-linear problem that may be solved iteratively with standard methods.

This may be performed online by the estimator (32).

As another computational less demanding solution, in a first step the estimator (32) may minimize the performance index J with the angular error $\delta$ set to zero. The result of the first step is an intermediate equivalent impedance $Z_{eq}$, which does not account for a deviation of the grid voltage from a nominal voltage. $Z_{eq}$ may be determined from $X_{eq}$ as defined below (9).

In a second step, the performance index J is minimized with the equivalent impedance $Z_{eq}$ set to the intermediate equivalent impedance $Z_{eq}$. The vector $\lambda$ determined in the previous step may be kept fixed and the the angular error $\delta$ may be determined.

In a third step, the performance index J is minimized with the angular error $\delta$ determined in the second step kept fixed for determining a final equivalent impedance $Z_{eq}$.

LIST OF REFERENCE SYMBOLS

| | |
|---|---|
| 10 | power plant |
| 12 | generator |
| 14 | control system |
| 16 | common connection point |
| 18 | power grid |
| 20 | transformer |
| 22 | circuit breaker |
| 24 | measurement and synchronisation unit |
| 26 | controller |
| 30 | excitation system |
| 32 | grid impedance estimator |
| $V_s$ | equivalent voltage source |
| $V_{gen}$ | generator voltage |
| $I_{gen,i}$ | generator current |
| $Z_g$ | grid impedance |
| $Z_{eq}$ | equivalent impedance |
| $V_R$ | control voltage |
| $I_f$ | excitation current |
| $V_f$ | excitation voltage |
| $I_{gen}$ | plant/generator current |
| 34 | fault |
| 36 | fault clearance |
| 38 | correct value |

**Claims**

1. A method for estimating an equivalent impedance ($Z_{eq}$) of a power grid (18), the method comprising:

   measuring a plurality of measurement values of a generator voltage ($V_{gen}$) and a generator current ($I_{gen}$) of at least one generator (12) connected to the power grid (18);
   generating a performance index ($J$) from the plurality of measurement values, the performance index being a function of the measurement values and the grid impedance ($Z_{eq}$);
   determining the equivalent impedance ($Z_{eq}$) as the grid impedance, which minimizes the performance index ($J$);
   **characterized in that**
   the performance index ($J$) is additionally a function of an angular error ($\delta$), which accounts for a deviation of a grid frequency at a measurement of a measurement value from a nominal grid frequency, and the performance index ($J$) is additionally minimized with respect to the angular error ($\delta$).

2. The method of claim 1,
   wherein the performance index ($J$) is minimized in a first step with the angular error ($\delta$) set to zero for determining an intermediate equivalent impedance ($Z_{eq}$)
   wherein the performance index ($J$) is minimized in a second step with the equivalent impedance ($Z_{eq}$) set to the intermediate equivalent impedance ($Z_{eq}$) for determining the angular error ($\underline{\delta}$);
wherein the performance index (J) is minimized in a third step with the angular error ($\delta$) determined in the second step kept fixed for determining the equivalent impedance ($Z_{eq}$).

3. The method of claim 1 or 2,
wherein the measurement values are measured at a plurality of different operation points of the at least one generator (12);
wherein different operation points differ in a phase angle between the generator voltage ($V_{gen}$) and the generator current ($I_{gen}$), in a magnitude of the generator voltage ($V_{gen}$) and/or in a magnitude of the generator current ($I_{gen}$).

4. The method of one of the previous claims, further comprising:

actively varying an operation point of the generator (12), wherein the operation point is based on a phase angle between the generator voltage ($V_{gen}$) and the generator current ($I_{gen}$), on a magnitude of the generator voltage ($V_{gen}$), and/or on a magnitude of the generator current ($I_{gen}$);
measuring the plurality of measurement values during the variation of the operation point.

5. The method of one of the previous claims, further comprising:

detecting a fault in the power grid (18);
after clearance of the fault, measuring the plurality of measurement values and determining the equivalent impedance ($Z_{eq}$) as changed grid impedance.

6. The method of one of the previous claims, further comprising:

measuring branch currents of a plurality of generators (12) connected to the power grid (18);
determining the generator current ($I_{eq}$) as a sum of the branch currents..

7. The method of one of the previous claims,
wherein the performance index (J) is based on a grid model, which comprises solely the grid impedance ($Z_{eq}$) connected in series with an ideal voltage source ($V_s$) providing a grid voltage.

8. The method of one of the previous claims,
wherein the performance index (J) is the norm of a vector, the entries of the vector being based on a set of equations, such that by minimizing the performance index the set of equations is solved;
wherein each equation of the set of equations is an equation of the grid impedance ($Z_{eq}$), of the angular error ($\underline{\delta}$) and of measurement values at one measurement time, which models the power grid (18).

10.

11. The method of one of the previous claims,
wherein the performance index (J) is minimized by an iterative method.

12. The method of one of the previous claims, further comprising:
controlling the at least one generator (12) based on the equivalent impedance ($Z_{eq}$).

13. The method of one of the previous claims,
wherein a transformer and/or a circuit breaker is connected between the power grid and a measurement point at which the generator voltage and the grid current are measured;
wherein the equivalent impedance ($Z_{eq}$) includes a transformer impedance of the transformer (20) and/or a circuit breaker impedance of the circuit breaker (22).

14. An estimator (32) of a power plant (10), the estimator (32) being adapted for performing the method of one of the previous claims;
wherein the estimator comprises a central computing unit for online minimizing the performance index (J); or
wherein the estimator comprises distributed computing units for online minimizing the performance index (J).

15. A control system (14) for an electrical generator (12), the control system (14) comprising:

a grid impedance estimator (32) adapted for performing the method of claims 1 to 12;
at least one controller (26) for controlling the at least one generator (12); wherein the at least one controller (26) is adapted for controlling the generator (12) based on the equivalent impedance ($Z_{eq}$).

16. A power plant (10), comprising:

at least one generator (12) interconnected to a power grid (18);
a control system (14) according to claim 14 for controlling the at least one generator (12).

**Patentansprüche**

1. Verfahren zum Schätzen einer Ersatzimpedanz ($Z_{eq}$) eines Stromnetzes (18), wobei das Verfahren Folgendes umfasst:

Messen mehrerer Messwerte einer Generatorspannung ($V_{gen}$) und eines Generatorstroms ($I_{gen}$) mindestens eines Generators (12), der mit dem Stromnetz (18) verbunden ist;
Erzeugen eines Leistungsindex (J) aus den mehreren Messwerten, wobei der Leistungsindex eine Funktion der Messwerte und der Netzimpedanz ($Z_{eq}$) ist; und
Bestimmen der Ersatzimpedanz ($Z_{eq}$) als die Netzimpedanz, die den Leistungsindex (J) minimiert;
**dadurch gekennzeichnet, dass**
der Leistungsindex (J) zusätzlich eine Funktion eines Winkelfehlers ($\delta$), der eine Abweichung einer Netzfrequenz von einer Netznennfrequenz in einer Messung von Messwerten berücksichtigt, ist und der Leistungsindex (J) zusätzlich in Bezug auf den Winkelfehler ($\delta$) minimiert wird.

2. Verfahren nach Anspruch 1, wobei
der Leistungsindex (J) in einem ersten Schritt minimiert wird, wobei der Winkelfehler ($\delta$) zum Bestimmen einer Zwischenersatzimpedanz ($Z_{eq}$) gleich null gesetzt ist;
der Leistungsindex (J) in einem zweiten Schritt minimiert wird, wobei die Ersatzimpedanz ($Z_{eq}$) zum Bestimmen des Winkelfehlers ($\delta$) zur Zwischenersatzimpedanz ($Z_{eq}$) gesetzt ist; und
der Leistungsindex (J) in einem dritten Schritt minimiert wird, wobei der Winkelfehler ($\delta$), der im zweiten Schritt bestimmt wurde, zum Bestimmen der Ersatzimpedanz ($Z_{eq}$) festgehalten wird.

3. Verfahren nach Anspruch 1 oder 2, wobei
die Messwerte bei mehreren verschiedenen Betriebspunkten des mindestens einen Generators (12) gemessen werden und
verschiedene Betriebspunkte sich in einem Phasenwinkel zwischen der Generatorspannung ($V_{gen}$) und dem Generatorstrom ($I_{gen}$), in einem Betrag der Generatorspannung ($V_{gen}$) und/oder in einem Betrag des Generatorstroms ($I_{gen}$) unterscheiden.

4. Verfahren nach einem der vorhergehenden Ansprüche, das ferner Folgendes umfasst:

aktives Variieren eines Betriebspunkts des Generators (12), wobei der Betriebspunkt einen Phasenwinkel zwischen der Generatorspannung ($V_{gen}$) und dem Generatorstrom ($I_{gen}$), einen Betrag der Generatorspannung ($V_{gen}$) und/oder einen Betrag des Generatorstroms ($I_{gen}$) als Grundlage verwendet; und
Messen der mehreren Messwerte während des Variierens des Betriebspunkts.

5. Verfahren nach einem der vorhergehenden Ansprüche, das ferner Folgendes umfasst:

Detektieren eines Fehlers im Stromnetz (18) und
Messen nach einer Beseitigung des Fehlers der mehreren Messwerte und Bestimmen der Ersatzimpedanz ($Z_{eq}$) als geänderte Netzimpedanz.

6. Verfahren nach einem der vorhergehenden Ansprüche, das ferner Folgendes umfasst:

Messen von Zweigströmen mehrerer Generatoren (12), die mit dem Stromnetz (18) verbunden sind; und
Bestimmen des Generatorstroms ($I_{gen}$) als eine Summe der Zweigströme.

**7.** Verfahren nach einem der vorhergehenden Ansprüche, wobei
der Leistungsindex (J) ein Netzmodell als Grundlage verwendet, das lediglich die Netzimpedanz ($Z_{eq}$) umfasst, die mit einer idealen Spannungsquelle ($V_s$), die eine Netzspannung liefert, in Reihe geschaltet ist.

**8.** Verfahren nach einem der vorhergehenden Ansprüche, wobei
der Leistungsindex (J) die Norm eines Vektors ist, wobei die Einträge des Vektors einen Satz Gleichungen derart als Grundlage verwenden, dass durch Minimieren des Leistungsindex der Satz Gleichungen gelöst wird; und
jede Gleichung des Satzes Gleichungen eine Gleichung der Netzimpedanz ($Z_{eq}$), des Winkelfehlers ($\delta$) und von Messwerten zu einer Messzeit ist, die das Stromnetz (18) modelliert.

**10.**

**11.** Verfahren nach einem der vorhergehenden Ansprüche, wobei
der Leistungsindex (J) durch ein iteratives Verfahren minimiert wird.

**12.** Verfahren nach einem der vorhergehenden Ansprüche, das ferner Folgendes umfasst:
Steuern des mindestens einen Generators (12) auf der Grundlage der Ersatzimpedanz ($Z_{eq}$).

**13.** Verfahren nach einem der vorhergehenden Ansprüche, wobei
ein Transformator und/oder ein Leistungsschalter zwischen dem Stromnetz und einem Messpunkt, bei dem die Generatorspannung und der Netzstrom gemessen werden, verbunden ist; und
die Ersatzimpedanz ($Z_{eq}$) eine Transformatorimpedanz des Transformators (20) und/oder eine Leistungsschalterimpedanz des Leistungsschalters (22) enthält.

**14.** Schätzvorrichtung (32) eines Kraftwerks (10), wobei die Schätzvorrichtung (32) ausgelegt ist zum Durchführen des Verfahrens eines der vorhergehenden Ansprüche; wobei
die Schätzvorrichtung eine Zentraleinheit zur Online-Minimierung des Leistungsindex (J) umfasst; oder
die Schätzvorrichtung verteilte Recheneinheiten zur Online-Minimierung des Leistungsindex (J) umfasst.

**15.** Steuersystem (14) für einen Stromgenerator (12), wobei das Steuersystem (14) Folgendes umfasst:

eine Netzimpedanzschätzvorrichtung (32), die ausgelegt ist zum Durchführen des Verfahrens der Ansprüche 1 bis 12; und
mindestens eine Steuereinheit (26) zum Steuern des mindestens einen Generators (12), wobei
die mindestens eine Steuereinheit (26) ausgelegt ist zum Steuern des Generators (12) auf der Grundlage der Ersatzimpedanz ($Z_{eq}$).

**16.** Kraftwerk (10), das Folgendes umfasst:

mindestens einen Stromgenerator (12), der mit einem Stromnetz (18) verbunden ist; und
ein Steuersystem (14) nach Anspruch 14 zum Steuern des mindestens einen Generators (12).

**Revendications**

**1.** Procédé d'estimation de l'impédance équivalente ($Z_{eq}$) d'un réseau d'électricité (18), le procédé comprenant :

la mesure d'une pluralité de valeurs de mesure d'une tension de générateur ($V_{gen}$) et d'un courant de générateur ($I_{gen}$) d'au moins un générateur (12) relié au réseau d'électricité (18),
la génération d'un indice de performance (J) à partir de la pluralité de valeurs de mesure, l'indice de performance étant une fonction des valeurs de mesure et de l'impédance du réseau ($Z_{eq}$),
la détermination de l'impédance équivalente ($Z_{eq}$) comme impédance du réseau, ce qui minimise l'indice de performance (J),
**caractérisé en ce que** :
l'indice de performance (J) est de plus une fonction d'une erreur angulaire ($\delta$) qui compte pour l'écart de la fréquence du réseau à une mesure d'une valeur de mesure par rapport à la fréquence nominale du réseau, et
l'indice de performance (J) et de plus minimisé par rapport à l'erreur angulaire ($\delta$).

**2.** Procédé selon la revendication 1,
dans lequel l'indice de performance ($J$) est minimisé lors d'une première étape où l'erreur angulaire ($\delta$) est positionnée à zéro afin de déterminer une impédance équivalente ($Z_{eq}$) intermédiaire,
dans lequel l'indice de performance ($J$) est minimisé lors d'une deuxième étape où l'impédance équivalente ($Z_{eq}$) est établie à l'impédance équivalente ($Z_{eq}$) intermédiaire afin de déterminer l'erreur angulaire ($\delta$),
dans lequel l'indice de performance ($J$) est minimisé lors d'une troisième étape où l'erreur angulaire ($\delta$), déterminée dans la seconde étape, est maintenue fixe afin de déterminer l'impédance équivalente ($Z_{eq}$).

**3.** Procédé selon la revendication 1 ou la revendication 2,
dans lequel les valeurs de mesure sont mesurées au niveau d'une pluralité de différents points de fonctionnement d'au moins un générateur (12),
dans lequel les différents points de fonctionnement diffèrent selon l'angle de phase entre la tension de générateur ($V_{gen}$) et le courant de générateur ($I_{gen}$) dans un ordre d'amplitude de la tension de générateur ($V_{gen}$) et/ou dans un ordre d'amplitude du courant de générateur ($I_{gen}$).

**4.** Procédé selon l'une des revendications précédentes, comprenant en outre :

la variation active d'un point de fonctionnement du générateur (12), le point de fonctionnement étant fondé sur l'angle de phase entre la tension de générateur ($V_{gen}$) et le courant de générateur ($I_{gen}$) sur un ordre d'amplitude de la tension de générateur ($V_{gen}$) et/ou sur un ordre d'amplitude du courant de générateur ($I_{gen}$),
la mesure de la pluralité de valeurs de mesure pendant la variation du point de fonctionnement.

**5.** Procédé selon l'une des revendications précédentes, comprenant en outre :

la détection d'un défaut dans le réseau d'électricité (18),
après l'élimination du défaut, la mesure de la pluralité de valeurs de mesure et la détermination de l'impédance équivalente ($Z_{eq}$) comme impédance de réseau modifiée.

**6.** Procédé selon l'une des revendications précédentes, comprenant en outre :

la mesure de courants de branches de la pluralité de générateurs (12) reliés au réseau d'électricité (18),
la détermination du courant de générateur ($I_{gen}$) comme étant la somme des courants de branches.

**7.** Procédé selon l'une des revendications précédentes,
dans lequel l'indice de performance ($J$) est fondé sur un modèle de réseau qui comprend uniquement l'impédance du réseau ($Z_{eq}$) reliée en série avec une source de tension ($V_s$) idéale délivrant la tension du réseau.

**8.** Procédé selon l'une des revendications précédentes,
dans lequel l'indice de performance ($J$) représente la norme d'un vecteur, les entrées du vecteur étant fondées sur un jeu d'équations de sorte qu'en minimisant l'indice de performance, le jeu d'équations est résolu,
dans lequel chaque équation du jeu d'équations est une équation de l'impédance du réseau ($Z_{eq}$), de l'erreur angulaire ($\delta$) et de valeurs de mesure à un instant de mesure, qui modélise le réseau d'électricité (18).

**10.**

**11.** Procédé selon l'une des revendications précédentes,
dans lequel l'indice de performance ($J$) est minimisé grâce à un procédé itératif.

**12.** Procédé selon l'une des revendications précédentes, comprenant en outre :
la commande du ou des générateurs (12) sur la base de l'impédance équivalente ($Z_{eq}$).

**13.** Procédé selon l'une des revendications précédentes,
dans lequel un transformateur et/ou un disjoncteur est relié entre le réseau et un point de mesure auquel sont mesurés la tension du générateur et le courant du réseau,
dans lequel l'impédance équivalente ($Z_{eq}$) inclut l'impédance du transformateur (20) et/ou l'impédance du disjoncteur (22).

**14.** Dispositif d'estimation (32) d'une centrale électrique (10), le dispositif d'estimation (32) étant conçu pour effectuer le procédé conforme à l'une des revendications précédentes,
où le dispositif d'estimation comprend une unité centrale destinée à minimiser en ligne l'indice de performance ($J$), ou où le dispositif d'estimation comprend des unités de calcul réparties pour minimiser en ligne l'indice de performance ($J$).

15. Système de commande (14) pour un générateur électrique (12), le système de commande (14) comprenant :

un dispositif d'estimation d'impédance de réseau (32) conçu pour effectuer le procédé conforme aux revendications 1 à 12,
au moins un contrôleur (26) destiné à commander le ou les générateurs (12), le ou les contrôleurs (26) étant conçus pour commander le générateur (12) sur la base de l'impédance équivalente ($Z_{eq}$).

16. Centrale électrique (10) comprenant :

au moins un générateur (12) interconnecté à un réseau d'électricité (18),
un système de commande (14) conforme à la revendication 14 permettant de commander le ou les générateurs (12).

# Fig. 1

# Fig. 2

# Fig. 3

# Fig. 4

## Fig. 5

## Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20150025860 A1

**Non-patent literature cited in the description**

• Grid Impedance Monitoring System for Distributed Power Generation Electronics Interfaces. **COBREC-ES.** IEEE Transactions on instrumentation and measurement. IEEE service center, 01 September 2009, vol. 58, 3112-3121